# EUROPEAN PATENT APPLICATION

(11) **EP 4 350 780 A1**
(43) Date of publication of application: **10.04.2024**
(21) Application number: 22816083.4
(22) Date of filing: 31.05.2022
(51) Int. Cl.: H01L 31/0224, H01L 31/0749

(54) **PHOTOELECTRIC CONVERSION ELEMENT, SOLAR CELL MODULE, AND PADDLE**

(30) Priority: 31.05.2021 JP 2021091105
(71) Applicant: Idemitsu Kosan Co.,Ltd., Tokyo 100-8321 (JP)
(72) Inventor: ISHIUCHI Takato, Tokyo 100-8321 (JP); HORIGUCHI Kyohei, Tokyo 100-8321 (JP); HAMANO Mikio, Tokyo 100-8321 (JP)
(74) Representative: Hoffmann Eitle
(86) International application number: PCT/JP2022/022062
(87) International publication number: WO 2022/255337

(57) **Abstract**

Provided is a photoelectric conversion element having high resistance to a temperature change. A photoelectric conversion element (10) comprises: a photoelectric conversion layer (26); an electrode layer (24) adjacent to the photoelectric conversion layer (26); and a collecting electrode (30) adjacent to the electrode layer (24). The collecting electrode (30) has a line-like first portion (31). Where L is a length of the first portion (31), W is a width of the first portion (31), and D is a thickness of the first portion (31), "D × L/W" is less than 2.5 × 10³ µm.

## Description

### Technical Field

The present invention relates to a photoelectric conversion element, a solar cell module, and a paddle.

### Background Art

A photoelectric conversion element that converts light energy into electric energy is known (Patent Literature 1). The photoelectric conversion element described in Patent Literature 1 includes a substrate made of an insulating material, a back electrode layer formed on the substrate, a power generation layer formed on the back electrode layer, a transparent electrode layer formed on the power generation layer, and a collecting electrode formed on the transparent electrode layer, the collecting electrode being made of metal.

In Patent Literature 1, the collecting electrode includes a plurality of finger portions that collect electrons from the transparent electrode layer, and a bus bar portion that further collect electrons collected by the finger portions. The finger portion is formed in an elongated line-like shape extending from the bus bar portion.

### Citation List

### Patent Literature

Patent Literature 1: JP 2009-302274 A

### Summary

The inventors of the present application found a problem that peeling may occur in a layer constituting a photoelectric conversion element at a position of a collecting electrode due to a temperature change in the photoelectric conversion element. When such peeling occurs, the photoelectric conversion efficiency of the photoelectric conversion element may decrease, or the photoelectric conversion function may be lost.

Therefore, a photoelectric conversion element having high resistance to a temperature change is desired.

A photoelectric conversion element according to one aspect comprises: a photoelectric conversion layer; an electrode layer adjacent to the photoelectric conversion layer; and a collecting electrode adjacent to the electrode layer. The collecting electrode has a line-like first portion. Where L is a length of the first portion, W is a width of the first portion, and D is a thickness of the first portion, "D × L/W" is less than 2.5 × 10³ pm.

### Brief Description of Drawings

Fig. 1 is a schematic plan view of a photoelectric conversion element according to a first embodiment.
Fig. 2 is an enlarged view in the vicinity of a region 2A in Fig. 1.
Fig. 3 is a schematic cross-sectional view of the photoelectric conversion element taken along line 3A-3A in Fig. 2.
Fig. 4 is a schematic plan view of a solar cell module including a photoelectric conversion element.
Fig. 5 is a schematic perspective view of an artificial satellite including a solar cell module.

### Description of Embodiments

Hereinafter, embodiments will be described with reference to the drawings. In the following drawings, the same or similar parts are denoted by the same or similar reference numerals. However, it should be noted that the drawings are schematic, and ratios of dimensions and the like may be different from actual ones.

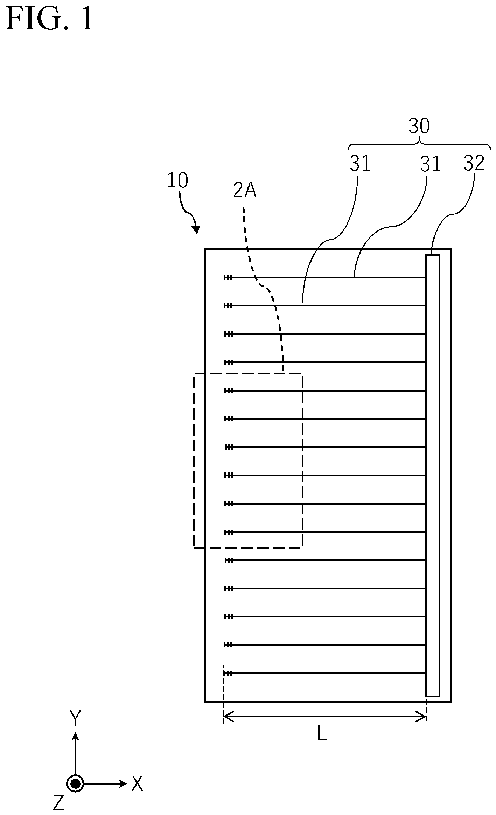

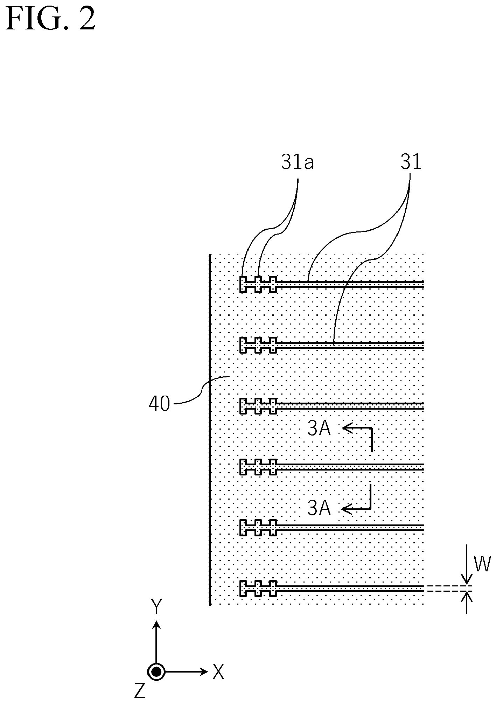

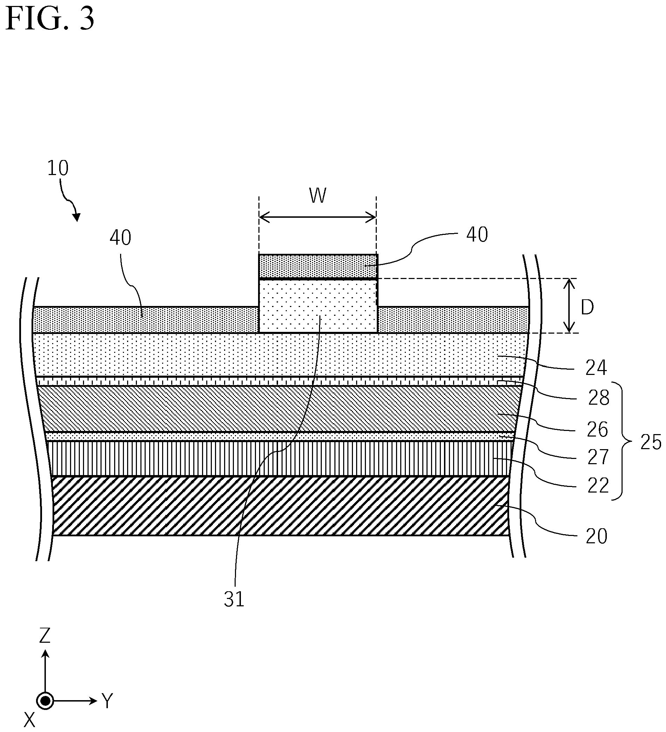

Fig. 1 is a schematic plan view of a photoelectric conversion element according to a first embodiment. Fig. 2 is an enlarged view in the vicinity of a region 2A in Fig. 1. Fig. 3 is a schematic cross-sectional view of the photoelectric conversion element taken along line 3A-3A in Fig. 2. Note that in Fig. 2, a reflection suppressing film 40 on a collecting electrode 30, which will be described later, is not illustrated for convenience of description.

A photoelectric conversion element 10 according to the present embodiment may be a photoelectric conversion element of a thin film type. Preferably, the photoelectric conversion element 10 is a solar cell element that converts light energy into electrical energy. A substrate 20 may be constructed by, for example, glass, ceramics, resin, metal, or the like.

The photoelectric conversion element 10 may include at least a first electrode layer 22, a second electrode layer 24, and a laminated body 25 provided between the first electrode layer 22 and the second electrode layer 24. The laminated body 25 may include a photoelectric conversion layer 26 that contributes to mutual conversion of light energy and electric energy. In a solar cell element that converts light energy into electric energy, the photoelectric conversion layer 26 may be referred to as a light absorption layer.

The first electrode layer 22 and the second electrode layer 24 are adjacent to the photoelectric conversion layer 26. In the present description, the term "adjacent" shall mean not only that both layers are in direct contact but also that both layers are in proximity via another layer.

The first electrode layer 22 is provided between the photoelectric conversion layer 26 and the substrate 20. The second electrode layer 24 is located on a side opposite to the substrate 20 with respect to the photoelectric conversion layer 26. Therefore, the first electrode layer 22 is located on a side opposite to the second electrode layer 24 with respect to the photoelectric conversion layer 26.

In the present embodiment, the second electrode layer 24 may be constituted by a transparent electrode layer. When the second electrode layer 24 is constituted by a transparent electrode layer, light incident on the photoelectric conversion layer 26 or emitted from the photoelectric conversion layer 26 passes through the second electrode layer 24.

When the second electrode layer 24 is constituted by a transparent electrode layer, the first electrode layer 22 may be constituted by an opaque electrode layer or may be constituted by a transparent electrode layer. The first electrode layer 22 may be formed of, for example, a metal such as molybdenum, titanium, or chromium.

In the present embodiment, as a preferred example, the second electrode layer 24 may be formed of an n-type semiconductor, more specifically, a material having n-type conductivity and relatively low resistance. The second electrode layer 24 may include, for example, a metal oxide to which a group III element (B, Al, Ga, or In) is added as a dopant. Examples of the metal oxide include ZnO and SnO₂. The second electrode layer 24 can be selected, as an example of the above-described material or another material, from In₂O₃ (indium oxide), ITO (indium tin oxide), ITiO (indium titanium oxide), IZO (indium zinc oxide), ZTO (zinc tin oxide), FTO (fluorine doped tin oxide), GZO (gallium doped zinc oxide), BZO (boron doped zinc oxide), AZO (aluminum doped zinc oxide), hydrogen doped indium oxide, and the like. The second electrode layer 24 can function as both an n-type semiconductor and a transparent electrode layer.

The photoelectric conversion layer 26 may include, for example, a p-type semiconductor. In a specific example, the photoelectric conversion layer 26 may function as, for example, a p-type compound semiconductor layer of polycrystalline or microcrystalline. The photoelectric conversion layer 26 may have a CIS-based light absorption layer. In an example of the CIS-based light absorption layer, the photoelectric conversion layer 26 is formed of a group I-III-VI₂ compound semiconductor having a chalcopyrite structure containing a group I element (Cu, Ag, Au, etc.), a group III element (Al, Ga, In, etc.), and a group VI element (O, S, Se, Te, etc.). Alternatively, the photoelectric conversion layer 26 is not limited to those described above, and may be constructed by any material that causes photoelectric conversion. The photoelectric conversion layer 26 may contain an alkali metal such as Li, Na, K, Rb, or Cs.

It should be noted that the laminated structure of the photoelectric conversion element 10 is not limited to the above aspect, and may have any of various aspects. For example, the photoelectric conversion element 10 may have a configuration in which both the n-type semiconductor and the p-type semiconductor are sandwiched between the first electrode layer and the second electrode layer. In this case, the second electrode layer need not be constituted by an n-type semiconductor. In addition, the photoelectric conversion element 10 is not limited to the p-n junction type structure, and may have a p-i-n junction type structure including an intrinsic semiconductor layer (i-type semiconductor) between an n-type semiconductor and a p-type semiconductor.

The laminated body 25 may have a second buffer layer 28 between the photoelectric conversion layer 26 and the second electrode layer 24 as necessary. In this case, the second buffer layer 28 may be a semiconductor material having the same conductivity type as the second electrode layer 24, or may be a semiconductor material having a different conductivity type. The second buffer layer 28 may be constructed by a material having higher electric resistance than that of the second electrode layer 24.

In the CIS-based photoelectric conversion element, the second buffer layer 28 may be, for example, a Zn-based buffer layer, a Cd-based buffer layer, or an In-based buffer layer. The Zn-based buffer layer may be, for example, ZnS, ZnO, Zn(OH)₂, ZnMgO, or a mixture, a mixed crystal, or a laminated body thereof. The Cd-based buffer layer may be, for example, CdS, CdO, Cd(OH)₂, or a mixture, a mixed crystal, or a laminated body thereof. The In-based buffer layer may be, for example, In₂S₃, In₂O₃, In(OH)₃, or a mixture, a mixed crystal, or a laminated body thereof.

The laminated body 25 may have a first buffer layer 27 between the photoelectric conversion layer 26 and the first electrode layer 22 as necessary. In this case, the first buffer layer 27 may be a semiconductor material having the same conductivity type as the first electrode layer 22, or may be a semiconductor material having a different conductivity type. The first buffer layer 27 may be constructed by a material having higher electric resistance than that of the first electrode layer 22.

The first buffer layer 27 is not particularly limited, but may be, for example, a layer containing a chalcogenide compound of a transition metal element having a layered structure. Specifically, the first buffer layer 27 may be constructed by a compound containing a transition metal material such as Mo, W, Ti, V, Cr, Nb, or Ta and a chalcogen element such as O, S, or Se. The first buffer layer 27 may be, for example, a Mo(Se,S)₂ layer, a MoSe₂ layer, a MoS₂ layer, a CrₓTaS₂ layer, or the like. The layer having the above-described layered structure is a layer having cleavability. The layer having cleavability may be a layer having a hexagonal crystal structure.

The photoelectric conversion element 10 includes a collecting electrode 30 adjacent to the second electrode layer 24. The collecting electrode 30 collects charge carriers from the second electrode layer 24, and is formed of a conductive material. The collecting electrode 30 may be in direct contact with the second electrode layer 24. The collecting electrode 30 may have a first portion 31 that has substantially line-like shape and a second portion 32 connected to the first portion 31.

The collecting electrode 30 (the first portion 31 and the second portion 32) may be formed by a material having higher conductivity than that of the material constituting the second electrode layer 24. The collecting electrode 30 (the first portion 31 and the second portion 32) may include, for example, one or a plurality of materials selected from Ni, Mo, Ti, Cr, Al, Ag, Cu, Au, and the like. The collecting electrode 30 may include an alloy or a laminated body formed by a combination of the above-described materials.

In the illustrated aspect, the substantially line-like first portion 31 extends straight along one direction (X direction in the drawing). Alternatively, the first portion 31 may extend in a wavy line shape or a zigzag polygonal line shape. In the present specification, the term "line-like" is defined by a concept including not only a straight line but also an elongated curved line such as a wavy line or a polygonal line.

A plurality of the first portions 31 of the collecting electrode 30 may be provided side by side in the first direction (Y direction in the drawing). The plurality of first portions 31 may be connected to the same second portion 32.

The first portion 31 of the collecting electrode 30 may have, at an end opposite to the second portion 32, one or a plurality of protrusions 31a protruding in a direction (Y direction in the drawing) intersecting a direction in which the line-like first portion 31 extends. Since a region of an end (free end) of the first portion 31 is expanded by the protrusion 31a, thermal stress generated in the region of the end (free end) of the first portion 31 can be dispersed. In the illustrated form, the plurality of protrusions 31a are provided in the region of the end (free end) of the first portion 31.

The second portion 32 of the collecting electrode 30 may extend in a first direction (Y direction in the drawing). The second portion 32 may be connected to the first portion 31 at an end of the first portion 31. In this case, the plurality of first portions 31 may extend from the second portion 32 along the second direction. Note that the second direction is a direction (X direction in the drawing) intersecting the above-described first direction.

The second portion 32 of the collecting electrode 30 may extend from substantially the vicinity of one end to the vicinity of the other end of the photoelectric conversion element 10 in the first direction (Y direction in the drawing). The second portion 32 of the collecting electrode 30 may be larger than each of the first portions 31. For example, the width of the second portion 32 in the X direction in the drawing may be larger than the width of the first portion 31 in the Y direction in the drawing.

Furthermore, the photoelectric conversion element 10 may include a reflection suppressing film 40 that suppresses reflection of light. The reflection suppressing film 40 may be provided on, for example, both the collecting electrode 30 and the second electrode layer 24 on which the collecting electrode 30 is not formed.

The inventor of the present application found that the photoelectric conversion element is peeled off or destroyed by a temperature cycle test at the free end of the first portion 31 of the collecting electrode 30 according to a design of length, width, and thickness of the first portion 31 of the collecting electrode 30. From such a viewpoint, the inventor has found a preferable condition regarding the length, the width, and the thickness of the first portion 31 of the collecting electrode 30. Hereinafter, the condition will be described.

Hereinafter, the length of the first portion 31 along the direction in which the first portion 31 extends (X direction in the drawing) is referred to as "L". Specifically, the length L of the first portion 31 is defined by a distance from a connection portion of the first portion 31 with the second portion 32 to an end of the first portion 31 opposite to the second portion 32.

In addition, the width of the first portion 31 in a direction (Y direction in the drawing) intersecting the direction in which the first portion 31 extends is referred to as "W". Note that the width W may be a width of a portion not including the protrusion 31a described above. Furthermore, the thickness of the first portion 31 is denoted by "D".

The first portion 31 of the collecting electrode 30 thermally expands/contracts due to a temperature change. One end of the first portion 31 is fixed to a relatively large second portion 32 (fixed end). Therefore, the other end portion (free end) of the first portion 31 thermally expands and contracts on a relatively free basis. That is, it is considered that an influence of thermal stress generated in the first portion 31 of the collecting electrode 30 is concentrated on the free end of the first portion 31.

Furthermore, it is considered that the concentration of the thermal stress also affects the width W of the first portion 31. That is, when the width W of the first portion 31 is small, an area of the first portion 31 is small, so that the thermal stress concentrates on a local region accordingly. Therefore, a degree of concentration (density) of the thermal stress in the vicinity of the free end of the first portion 31 is substantially proportional to a ratio of the length L and the width W of the first portion 31 (hereinafter referred to as "aspect ratio L/W").

It is known that a thermal stress generated in a thin film is proportional to a film thickness. Therefore, the thermal stress generated in the first portion 31 of the collecting electrode 30 is also proportional to a thickness D. Therefore, it can be seen that the degree of concentration (density) of the thermal stress in the vicinity of the free end of the first portion 31 is generally expressed by an index of "D × L/W".

From the above viewpoint, as a value of "D × L/W" is smaller, durability against a temperature change can be improved at the free end of the first portion 31 of the collecting electrode 30. From this viewpoint, in the present embodiment, "D × L/W" is less than 2.5 × 10³ um, and may be, for example, 2.4 × 10³ um or less. Preferably, "D × L/W" is 2.2 × 10³ um or less. More preferably, "D × L/W" is 1.8 × 10³ um or less. Furthermore preferably, "D × L/W" is 1.4 × 10³ um or less. As a result, as described in detail below, a photoelectric conversion element having high resistance to a temperature change can be provided. Note that a lower limit value of "D × L/W" is not particularly limited, and it is sufficient that "D × L/W" is, for example, larger than 0.

Furthermore, from the viewpoint of suppressing the concentration of thermal stress itself depending on the aspect ratio of the first portion 31 described above, "L/W" may be, for example, 6.25 × 10² or less. Preferably, "L/W" is 5.6 × 10² or less. More preferably, "L/W" is 5.0 × 10² or less. Furthermore preferably, "L/W" is 4.4 × 10² or less. Even more preferably, "L/W" is 3.6 × 10² or less. However, it should be noted that a value of "L/W" is set so as not to exceed the upper limit value of "D × L/W" described above. Note that "L/W" is not particularly limited, but may be, for example, larger than 1.0.

From the viewpoint of suppressing the thermal stress corresponding to the thickness D of the first portion 31 described above, the thickness D of the first portion 31 may be, for example, 12 um or less. Preferably, the thickness D of the first portion 31 is 8 um or less. More preferably, the thickness D of the first portion 31 is 6 um or less. Further preferably, the thickness D of the first portion 31 is 4 um or less. However, it should be noted that the thickness D of the first portion 31 is set so as not to exceed the upper limit value of "D × L/W" described above. The lower limit value of the thickness D of the first portion 31 is not particularly limited, and it is sufficient that the thickness D is, for example, larger than 0 µm.

### [Temperature Cycle Test]

Next, a result of performing a temperature cycle test on a photoelectric conversion element having a collecting electrode will be described. The configuration of the photoelectric conversion element used in the temperature cycle test is as shown in Fig. 3. In the photoelectric conversion element used in the temperature cycle test, a photoelectric conversion layer 26 was a CIS-based light absorption layer, a first electrode layer 22 was formed of molybdenum, a first buffer layer 27 was a Mo (Se, S)₂ layer, and a second electrode layer 24 was a transparent electrode layer.

The collecting electrode 30 (the first portion 31 and the second portion 32) was formed of a laminated body of nickel and silver. The thickness of nickel constituting the collecting electrode 30 was 10 nm. The total thickness of nickel and silver constituting the collecting electrode 30, that is, the thickness D described above was changed for each sample (condition) as shown in Table 1 below.

In addition, as shown in the following Table 1, a photoelectric conversion element including the collecting electrode 30 having the first portions 31 of different lengths L and widths W from each other was prepared, and a temperature cycle test was performed based on a difference in the length L, the width W, and the thickness D of the first portion 31. Note that the length L of the first portion 31 is defined by a distance from a connection portion of the first portion 31 with the second portion 32 to an end of the first portion 31 opposite to the second portion 32.

**(Table 1)**

| **Condition** | **Length L (µm)** | **Width W (µm)** | **Thickness D (µm)** | **Aspect ratio L/W** | **D × L/W (µm)** |
|---|---|---|---|---|---|
| 1 | 2.6 × 10⁴ | 100 | 2 | 2.6 × 10² | 5.2 × 10² |
| 2 | 3.6 × 10⁴ | 100 | 2 | 3.6 × 10² | 7.2 × 10² |
| 3 | 1.8 × 10⁴ | 100 | 4 | 1.8 × 10² | 7.2 × 10² |
| 4 | 2.6 × 10⁴ | 100 | 4 | 2.6 × 10² | 1.0 × 10³ |
| 5 | 1.8 × 10⁴ | 50 | 4 | 3.6 × 10² | 1.4 × 10³ |
| 6 | 3.6 × 10⁴ | 100 | 4 | 3.6 × 10² | 1.4 × 10³ |
| 7 | 2.6 × 10⁴ | 100 | 6 | 2.6 × 10² | 1.6 × 10³ |
| 8 | 3.6 × 10⁴ | 100 | 6 | 3.6 × 10² | 2.2 × 10³ |
| 9 | 3.6 × 10⁴ | 100 | 7 | 3.6 × 10² | 2.5 × 10³ |
| 10 | 3.6 × 10⁴ | 50 | 4 | 7.2 × 10² | 2.9 × 10³ |

Next, a photoelectric conversion element including a collecting electrode having the above conditions was disposed in a stainless steel mesh-shaped container (hereinafter, simply referred to as a "container"). Note that a thermometer (thermocouple) is attached to a bottom of the container. The container containing the photoelectric conversion element was subjected to a temperature cycle test in the following procedure under a nitrogen atmosphere. In the following description, Fluorinert is used as a heat bath, and liquid nitrogen is used as a cold bath.

(1) First, a container containing a photoelectric conversion element was immersed in a heat bath at 135°C, and left in the heat bath until a thermometer (thermocouple) showed a temperature of 125°C or higher.
(2) When the thermocouple showed a temperature of 125°C or higher, the container was removed from the heat bath and the container was immersed in the cold bath of - 196°C. Thereafter, the container was left in the cold bath until the thermocouple showed a temperature of -195°C or less.
(3) When the thermocouple showed a temperature of - 195°C or lower, the container was removed from the cold bath and the container was immersed again in the heat bath of 135°C. Thereafter, the container was left in the heat bath until the thermocouple showed a temperature of 125 °C or more.
(4) An operation described in (2) and (3) above was defined as 1 cycle, and a total of 500 cycles of operation were performed.
(5) Upon completion of a process of 500 cycle heating and cooling, the container was removed from the heat bath and slowly cooled to a room temperature under a nitrogen atmosphere.
(6) Thereafter, the collecting electrode of the photoelectric conversion element and the vicinity thereof were observed, and whether or not a layer constituting the photoelectric conversion element was peeled off at the collecting electrode was investigated.

The results of the temperature cycling tests are shown in Table 2 below.

**(Table 2)**

| **Condition** | **D × L/W (µm)** | **Peeling** |
|---|---|---|
| 1 | 5.2 × 10² | No |
| 2 | 7.2 × 10² | No |
| 3 | 7.2 × 10² | No |
| 4 | 1.0 × 10³ | No |
| 5 | 1.4 × 10³ | No |
| 6 | 1.4 × 10³ | No |
| 7 | 1.6 × 10³ | No |
| 8 | 2.2 × 10³ | No |
| 9 | 2.5 × 10³ | Occurred |
| 10 | 2.9 × 10³ | Occurred |

From the results shown in Table 2, it was found that when the "D × L/W" was 2.9 × 10³ um, the layer constituting the laminated body 25 was peeled off at a position of the first portion 31 of the collecting electrode 30. When the "D × L/W" was 1.4 × 10³ um or less, such peeling was not observed.

Here, the Japanese Industrial Standards "JIS C 8991: 2011" defines conditions for a temperature cycle test for a thin-film solar cell module installed on the ground. According to JIS C 8991: 2011, a temperature cycle test is performed under the condition that 200 cycles of temperature change from -40°C to 85°C are performed. Therefore, the temperature cycle test performed in the above experiment corresponds to a test that gives severe conditions to a photoelectric conversion element as compared with Japanese Industrial Standards "JIS C 8991: 2011".

Therefore, in a normal use environment of a photoelectric conversion element, it can be assumed that the photoelectric conversion element has sufficient resistance to a temperature change even if "D × L/W" is in a numerical range of less than 2.5 × 10³ pm.

Therefore, it can be seen that "D × L/W" is less than 2.5 × 10³ um, and may be, for example, 2.4 × 10³ um or less. According to the results shown in Table 2, when "D × L/W" is 2.2 × 10³ um or less, a photoelectric conversion element having high resistance to a temperature change can be provided more reliably.

Furthermore, the photoelectric conversion element that can withstand a higher temperature change as described above can be suitably used as a photoelectric conversion element for a mobile object mounted on a mobile object such as a car or an airplane, or a photoelectric conversion element for space or artificial satellite used at an altitude of 100 km or more or in an environment such as space.

In the temperature cycle test described above, it was found that when "D × L/W" was 2.9 × 10³ um, the layer constituting the laminated body 25 started to be peeled off from the end (free end) of the first portion 31 of the collecting electrode 30, and peeling proceeded from the free end. It was found that this peeling occurred at an interface between the Mo(Se,S)₂ layer and the CIS-based light absorbing layer. Here, the Mo(Se,S)₂ layer is a layer having a hexagonal crystal structure and has cleavability. That is, since the Mo(Se,S)₂ layer is a relatively weak layer, it is considered that peeling occurred at the Mo(Se,S)₂ layer.

It can be seen from the temperature cycle test described above that, even when the laminated body 30 includes a layer having such cleavability, peeling of the layer constituting the laminated body 30 can be suppressed by appropriately setting the conditions of the thickness D, the length L, and the width W of the first portion 31 of the collecting electrode 30.

Therefore, the above-described condition regarding "D × L/W" can be suitably used for a photoelectric conversion element including a layer having cleavability.

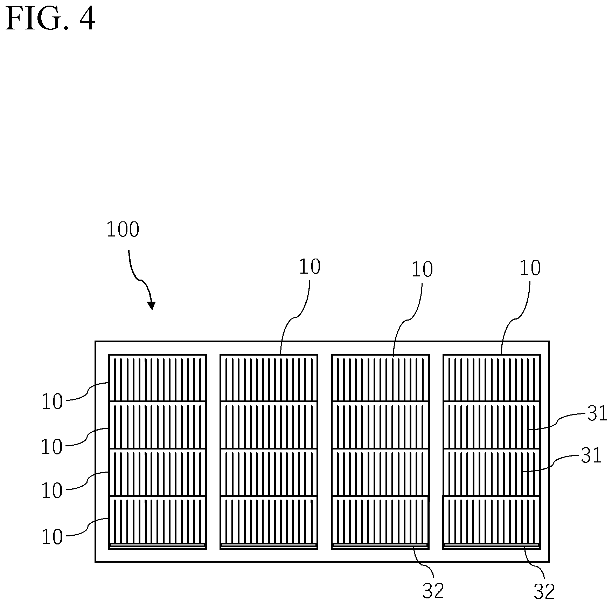

Next, a solar cell module including a photoelectric conversion element will be described. Fig. 4 is a schematic plan view of a solar cell module including a photoelectric conversion element. A solar cell module 100 may include one or a plurality of photoelectric conversion elements 10. Note that Fig. 4 illustrates the photoelectric conversion module 100 including a plurality of photoelectric conversion elements 10. The one or the plurality of photoelectric conversion elements 10 may be sealed with, for example, a sealing material.

When the photoelectric conversion module 100 includes the plurality of photoelectric conversion elements 10, the plurality of photoelectric conversion elements 10 may be disposed in at least one direction, and preferably may be disposed in a lattice pattern. In this case, the plurality of photoelectric conversion elements 10 may be electrically connected to each other in series and/or in parallel.

In an example illustrated in Fig. 4, the photoelectric conversion elements 10 are disposed so as to be partially overlapped each other. Among the photoelectric conversion elements 10 disposed in one direction, adjacent photoelectric conversion elements 10 are partially overlapped each other. Specifically, as illustrated in Fig. 4, a certain photoelectric conversion element 10 may be disposed so as to cover the second portion 32 of the collecting electrode 30 of the photoelectric conversion element 10 adjacent thereto. In this case, the photoelectric conversion element 10 is electrically connected to the second portion 32 of the collecting electrode 30 of the photoelectric conversion element 10 adjacent thereto.

Instead of the aspect illustrated in Fig. 4, the photoelectric conversion elements 10 adjacent to each other may be disposed at intervals. In this case, the photoelectric conversion module 100 may include a conductive interconnector (not illustrated) that electrically connects the second portion 32 of the collecting electrode 30 of a certain photoelectric conversion element 10 and the photoelectric conversion element 10 adjacent thereto.

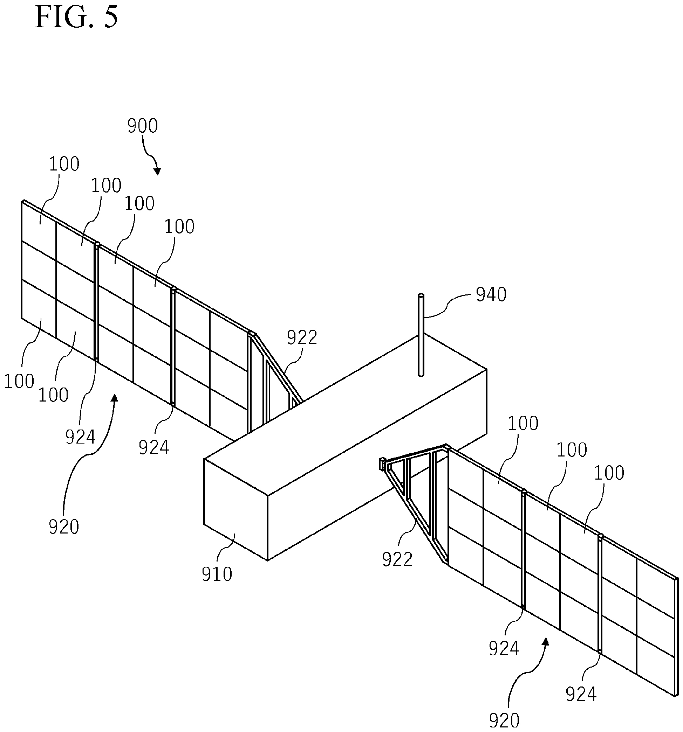

Next, an artificial satellite including a solar cell module, and a paddle for an artificial satellite will be described. Fig. 5 is a schematic perspective view of an artificial satellite including a solar cell module. An artificial satellite 900 may have a base 910 and a paddle 920. The base 910 may include a device (not illustrated) necessary for controlling the artificial satellite 900 and the like. An antenna 940 may be attached to the base 910.

The paddle 920 may include the solar cell module 100 described above. The paddle 920 including the solar cell module 100 can be used as a power supply for operating various devices provided on the base 910. As described above, the solar cell module 100 can be applied to a paddle for an artificial satellite. In particular, since the paddle 920 for an artificial satellite is exposed to a high temperature environment and a severe temperature change environment at the time of launching and operating the artificial satellite, it is desirable to use the solar cell module 100 including the photoelectric conversion element 10 having high resistance to the temperature change described above.

The paddle 920 may have a connection portion 922 and a hinge portion 924. The connection portion 922 corresponds to a portion connecting the paddle 920 to the base 910.

The hinge portion 924 extends along one direction, and the paddle 920 can be bent with the hinge portion 924 as a rotation axis. Each paddle 920 may have at least one, preferably a plurality of, hinges 924. Thus, the paddle 920 including the solar cell module 100 is configured to be foldable small. When the artificial satellite 900 is launched, the paddle 920 may be in a folded state. It is sufficient that the paddle 920 is unfolded when receiving sunlight to generate power.

Instead of the structure as illustrated in Fig. 5, the paddle 920 may have a cylindrical shape formed by being wound. Accordingly, the paddle 920 can take a substantially flat unfolded state by a rotation of the wound portion. When the artificial satellite 900 is launched, the paddle 920 may maintain a generally cylindrical shape. It is sufficient that the paddle 920 is unfolded so as to be in a substantially flat state when receiving sunlight to generate power.

As described above, the contents of the present invention have been disclosed through the embodiments, but it should not be understood that the description and the drawings constituting a part of the disclosure limit the present invention. From this disclosure, various alternative embodiments, examples, and operational techniques will become apparent to those skilled in the art. Therefore, the technical scope of the present invention is defined only by the matters specifying the invention according to the claims appropriate from the above description.

In the illustrated aspect, the collecting electrode 30 is provided on the second electrode layer 24. Alternatively, the collecting electrode 30 may be provided between the photoelectric conversion layer 26 and the second electrode layer 24.

In the embodiment described above, the second electrode layer 24 may be constituted by a transparent electrode layer. Alternatively, the first electrode layer 22 may be constituted by a transparent electrode layer. In this case, the second electrode layer 24 may be constituted by a transparent electrode layer or an opaque electrode layer.

Furthermore, in the illustrated aspect, the first portions 31 of all the collecting electrodes 30 formed in the same photoelectric conversion element have the same length L, width W, and thickness D. Alternatively, the plurality of first portions 31 formed in the same photoelectric conversion element may have different lengths L, widths W, and thicknesses D from each other. In this case, it is preferable that at least a part, preferably all, of the plurality of first portions 31 satisfy the above-described conditions regarding the length L, the width W, and the thickness D.

In addition, in the present embodiment, the thin-film photoelectric conversion element has been described as an example, but the present invention is not limited thereto, and can be applied to a crystalline photoelectric conversion element as much as possible. Even in the crystalline photoelectric conversion element, an influence of the thermal stress can be alleviated by setting the conditions regarding the length L, the width W, and the thickness D of the first portion 31 of the collecting electrode 30 as described above. However, from the viewpoint of suppressing peeling of the laminated body 25, it is particularly desirable to apply the present invention to a thin-film photoelectric conversion element.

In the above embodiment, the first portion 31 of the collecting electrode 30 has the protrusion 31a. Alternatively, the first portion 31 of the current collecting electrode 30 may have a substantially line-like shape without the protrusion 31a.

In the illustrated form, the first portion 31 of the collecting electrode 30 extends only in one direction from the second portion 32. Alternatively, the plurality of first portions 31 may extend in different directions from each other from the second portion 32. For example, the plurality of first portions 31 may extend in directions opposite to each other. Furthermore, a certain first portion 31 may extend in a direction inclined with respect to another first portion 31.

In the illustrated embodiment, the second portion 32 of the collecting electrode 30 extends straight in the Y direction. Alternatively, the second portion 32 of the collecting electrode 30 may extend in a wavy line shape or a zigzag polygonal line shape.

This application claims priority based on Japanese Patent Application No. 2021-091105 filed on May 31, 2021, the entire contents of which are incorporated herein by reference.

## Claims

1. A photoelectric conversion element comprising:
a photoelectric conversion layer;
an electrode layer adjacent to the photoelectric conversion layer; and
a collecting electrode adjacent to the electrode layer, wherein
the collecting electrode has a line-like first portion, and
where L is a length of the first portion, W is a width of the first portion, and D is a thickness of the first portion, "D × L/W" is less than 2.5 × 10³ pm.

2. The photoelectric conversion element according to claim 1, wherein the collecting electrode includes a plurality of the first portions and a second portion to which the plurality of first portions are connected.

3. The photoelectric conversion element according to claim 1 or 2, wherein "D × L/W" is 2.2 × 10³ um or less.

4. The photoelectric conversion element according to any one of claims 1 to 3, wherein the first portion has a thickness of 12 um or less.

5. The photoelectric conversion element according to any one of claims 1 to 4, wherein "L/W" is 6.25 × 10² or less.

6. The photoelectric conversion element according to any one of claims 1 to 5, wherein the first portion of the collecting electrode has, at an end of the first portion, a protrusion protruding in a direction intersecting a direction in which the first portion extends.

7. The photoelectric conversion element according to any one of claims 1 to 6, comprising:
another electrode layer provided on a side opposite to the electrode layer with respect to the photoelectric conversion layer; and
a laminated body provided between said another electrode layer and the electrode layer and including the photoelectric conversion layer, wherein
the laminated body includes a layer having cleavability.

8. The photoelectric conversion element according to claim 7, wherein the layer having cleavability is a layer having a hexagonal crystal structure.

9. The photoelectric conversion element according to any one of claims 1 to 8, wherein the photoelectric conversion layer includes a CIS-based light absorption layer.

10. A solar cell module comprising the photoelectric conversion element according to any one of claims 1 to 9.

11. A paddle comprising the solar cell module according to claim 10.
